# EUROPEAN PATENT APPLICATION

(11) **EP 2 696 208 A1**
(43) Date of publication of application: **12.02.2014**
(21) Application number: 12760267.0
(22) Date of filing: 13.03.2012
(51) Int. Cl.: G01R 31/02, E02F 9/20

(54) **CONSTRUCTION MACHINERY**

(30) Priority: 22.03.2011 JP 2011062990
(71) Applicant: Hitachi Construction Machinery Co., Ltd., Bunkyo-ku Tokyo 112-8563 (JP)
(72) Inventor: EDAMURA Manabu, Tsuchiura-shi Ibaraki 300-0013 (JP); HIROKI Takenori, Tsuchiura-shi Ibaraki 300-0013 (JP); SHIINA Masayuki, Tsuchiura-shi Ibaraki 300-0013 (JP); SHIBATA Kouichi, Tsuchiura-shi Ibaraki 300-0013 (JP)
(74) Representative: Beetz & Partner
(86) International application number: PCT/JP2012/056485
(87) International publication number: WO 2012/128133

(57) **Abstract**

Disclosed is a construction machine having an electric operating system. The electric operating system includes a first insulation resistance degradation detection device 90A, the detection device 90A including a first voltage waveform generation device 100A and a first detection section 99A, the first detection section 99A being connected to an electrical storage device 24 and to the first voltage waveform generation device 100A with respect to a relay 56 and adapted to detect degradation in the insulation resistance of the electrical storage device 24 by measuring waveform changes input from the first voltage waveform generation device 100A, and a second insulation resistance degradation detection device 90B, the detection device 90B including a second voltage waveform generation device 100B and a second detection section 99B, the second detection section 99B being connected to a drive system 55 and to the second voltage waveform generation device 100B with respect to the relay 56 and adapted to detect degradation in the insulation resistance of the drive system by measuring waveform changes input from the second voltage waveform generation device 100B.

## Description

### Technical Field

The present invention relates to a construction machine, and more particularly to a construction machine capable of detecting degradation in the insulation resistance between a vehicle body and an electric operating system having, for example, an electrical storage device and an electric motor.

### Background Art

A construction machine such as a hydraulic excavator uses gasoline, light oil, or other fuel as a motive power source and drives a hydraulic pump with an engine to generate hydraulic pressure, thereby driving a hydraulic actuator such as a hydraulic motor or a hydraulic cylinder. As the hydraulic actuator is compact, lightweight, and capable of generating high output, it is widely used as a construction machine actuator.

Meanwhile, a construction machine recently proposed, for instance, in Patent Document 1 uses an electric motor and electrical storage devices (e.g., a battery and an electric double layer capacitor) to provide increased energy savings by achieving higher energy efficiency than a conventional construction machine that uses only a hydraulic actuator.

The electric motor (electric actuator) excels in terms of energy conservation as it achieves higher energy efficiency than the hydraulic actuator and can generate electrical energy from kinetic energy during braking (the kinetic energy used during braking is released in the form of heat when the hydraulic actuator is used).

For example, Patent Document 1, which relates to a conventional technology, describes an embodiment of a hydraulic excavator that incorporates an electric motor as a swing structure drive actuator. An actuator that turnably drives a swing structure of the hydraulic excavator with respect to a travel structure (a hydraulic motor is conventionally used) is frequently used as it starts, stops, accelerates, and decelerates repeatedly at frequent intervals. In this instance, the kinetic energy of the swing structure that is used during deceleration (braking) is discarded in the form of heat within a hydraulic circuit when the hydraulic actuator is used. However, when the electric motor is used, energy saving can be achieved because the kinetic energy can be regenerated as electrical energy.

In the meantime, the electric actuator and electrical storage device incorporated in the above-mentioned hybrid hydraulic excavator are used at a high voltage and at a high current. Therefore, when the insulation resistance between a main electrical circuit and a vehicle body degrades, an electrical current may flow to the vehicle body through a portion degraded in terms of insulation resistance to create an electric shock hazard or other similar hazard.

Various insulation resistance degradation detection devices are proposed to address the above problem. For example, a certain device applies an AC signal having a predetermined frequency to a target circuit and measures the amplitude of the AC signal at a predefined measurement point to detect degradation in insulation resistance. A device disclosed, for instance, in Patent Document 2 is included in a system in which a booster circuit (e.g., chopper) is disposed between an electrical storage device and an inverter and capable of not only preventing erroneous detection during a booster circuit operation, but also detecting degradation in insulation resistance in a continuous manner.

Further, a certain technology not only detects degradation in insulation resistance, but also provides relay failure diagnosis for diagnosing the break function of a relay capable of opening and closing itself to break the connection between, for example, an electrical storage device, an electric actuator, and an inverter. A relay failure diagnosis device disclosed, for instance, in Patent Document 3 diagnoses a relay failure by using an insulation resistance degradation detection device.

Furthermore, another technology provides self abnormality diagnosis to detect an abnormality in an insulation resistance degradation detection device itself. An insulation resistance degradation detector having a simple configuration for diagnosing a local abnormality and a self abnormality diagnosis method employed by the insulation resistance degradation detector are disclosed, for instance, in Patent Document 4.

### Prior Art Documents

### Patent Documents

Patent Document 1: JP,A 2001-016704
Patent Document 2: JP,A 2009-109278
Patent Document 3: JP,A 2007-329045
Patent Document 4: PCT Publication No. WO2007/026603

### Summary of the Invention

### Problem to be Solved by the Invention

The conventional technologies described in Patent Documents 3 and 4 are mainly applied, for instance, to a field of electric vehicles having a high-voltage circuit.

Meanwhile, hybrid construction machines have a limited space for accommodating, for example, an insulation resistance degradation detection device. Therefore, a compact insulation resistance degradation detection system having a simple circuit configuration for implementing an insulation resistance degradation detection function, a relay failure diagnosis function, and a self abnormality diagnosis function has been demanded.

The present invention has been made in view of the above circumstances. An object of the present invention is to provide a construction machine that has a drive system having an electric motor and the like, an electrical storage device, and a relay for breaking the electrical connection between the electrical storage device and the drive system, and includes an insulation resistance degradation detection device having a simple circuit configuration for performing insulation resistance degradation detection, relay failure diagnosis, and self abnormality diagnosis.

### Means for Solving the Problem

In accomplishing the above object, according to a first aspect of the present invention, there is provided a construction machine including an electric operating system that has electric motors, a drive system including an electrical circuit and a controller for driving and controlling the electric motors, an electrical storage device, and a relay for electrically connecting the electrical storage device to the drive system and electrically disconnecting the electrical storage device from the drive system. The electric operating system includes a first insulation resistance degradation detection device, the detection device including a first voltage waveform generation device and a first detection section, the first detection section being connected to the electrical storage device and to the first voltage waveform generation device with respect to the relay and detects degradation in the insulation resistance of the electrical storage device by measuring waveform changes input from the first voltage waveform generation device, and a second insulation resistance degradation detection device, the detection device including a second voltage waveform generation device and a second detection section, the second detection section being connected to the drive system and to the second voltage waveform generation device with respect to the relay and detects degradation in the insulation resistance of the drive system by measuring waveform changes input from the second voltage waveform generation device.

According to a second aspect of the present invention, there is provided the construction machine as described in the first aspect, wherein the first and second detection sections in the first and second insulation resistance degradation detection devices are electrically connected to the second and first voltage waveform generation devices so as to acquire voltage waveforms from both the second and first voltage waveform generation devices in order to be able to verify the normality of the relay.

According to a third aspect of the present invention, there is provided the construction machine as described in the first aspect, wherein the first insulation resistance degradation detection device detects degradation in the insulation resistance around the electrical storage device when the relay is open.

According to a fourth aspect of the present invention, there is provided the construction machine as described in the first aspect, wherein the second insulation resistance degradation detection device is connected to positive and negative electrodes of the electrical circuit in the drive system through impedance elements.

According to a fifth aspect of the present invention, there is provided the construction machine as described in the first aspect, wherein the first and second insulation resistance degradation detection devices are disposed toward the drive system with respect to the relay, and wherein the first insulation resistance degradation detection device is connected from the drive system to the electrical storage device through a cable and another relay.

### Effects of the Invention

According to the present invention, a construction machine having a drive system with an electric motor and the like, an electrical storage device, and a relay for breaking the electrical connection between the electrical storage device and the drive system can perform insulation resistance degradation detection, relay failure diagnosis, and self abnormality diagnosis by using a simple circuit configuration.

### Brief Description of the Drawings

FIG. 1 is a side view illustrating an embodiment of a construction machine according to the present invention.
FIG. 2 is a system configuration diagram illustrating electric equipment and hydraulic equipment included in the embodiment of the construction machine according to the present invention.
FIG. 3 is an electrical circuit diagram illustrating an electric operating system included in the embodiment of the construction machine according to the present invention.

### Mode for Carrying Out the Invention

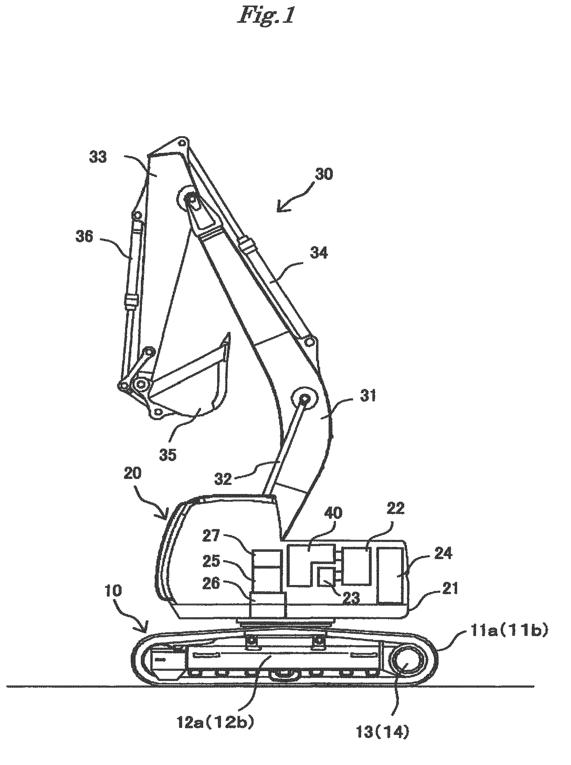

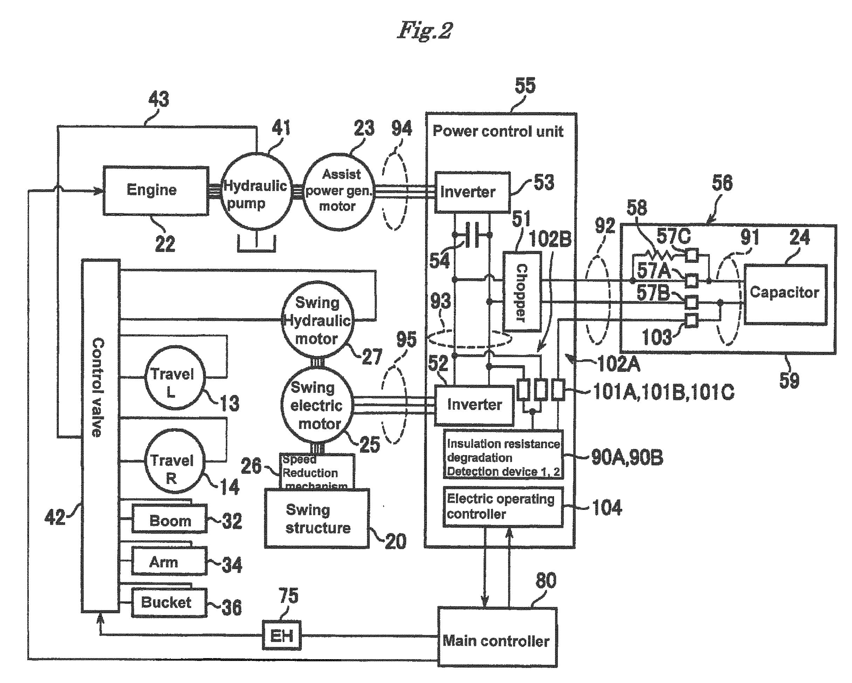

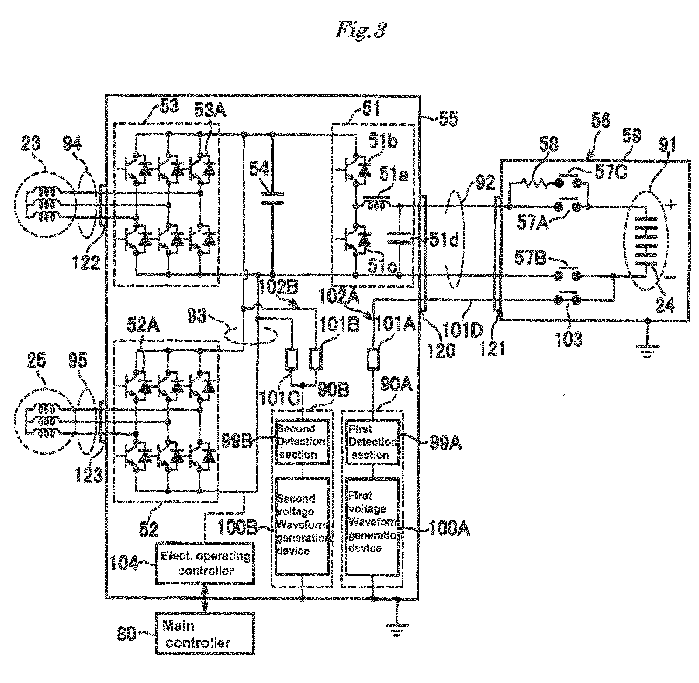

A construction machine according to an embodiment of the present invention will now be described with reference to the accompanying drawings. More specifically, a hydraulic excavator according to the present invention will be described as an example of the construction machine. The present invention is applicable to vehicles and general construction machines (including work machines) having an electrical storage device, a drive system with an electric motor, and a relay for disconnecting the electrical storage device from the drive system. The applicability of the present invention is not limited to hydraulic excavators. FIG. 1 is a side view illustrating an embodiment of the construction machine according to the present invention. FIG. 2 is a system configuration diagram illustrating electric equipment and hydraulic equipment included in the embodiment of the construction machine according to the present invention. FIG. 3 is an electrical circuit diagram illustrating an electric operating system included in the embodiment of the construction machine according to the present invention.

Referring to FIG. 1, a hybrid hydraulic excavator includes a travel structure 10, a swing structure 20 turnably mounted on the travel structure 10, and an excavator mechanism 30.

The travel structure 10 includes, for example, a pair of crawlers 11a, 11b, a pair of crawler frames 12a, 12b (only one of the crawler frames is shown in FIG. 1), a pair of travel hydraulic motors 13, 14 for providing independent drive control of the crawlers 11a, 11b, and a speed reduction mechanism for the travel hydraulic motors 13, 14.

The swing structure 20 includes, for example, a swing frame 21, an engine 22, an assist power generation motor 23, a swing electric motor 25, a swing hydraulic motor 27, an electric double layer capacitor 24, and a speed reduction mechanism 26. The engine 22 acts as a prime mover. The assist power generation motor 23 is driven by the engine 22. The electric double layer capacitor 24 is connected to the assist power generation motor 23 and to the swing electric motor 25. The speed reduction mechanism 26 reduces the rotation speed of the swing electric motor 25 and of the swing hydraulic motor 27. A driving force generated by the swing electric motor 25 and by the swing hydraulic motor 27 is transmitted through the speed reduction mechanism 26 to turnably drive the swing structure 20 (swing frame 21) with respect to the travel structure 10.

Further, the excavator mechanism (front device) 30 is mounted on the swing structure 20. The excavator mechanism 30 includes, for example, a boom 31, a boom cylinder 32 for driving the boom 31, an arm 33 rotatably supported by the vicinity of the leading end of the boom 31, an arm cylinder 34 for driving the arm 33, a bucket 35 rotatably supported by the leading end of the arm 33, and a bucket cylinder 36 for driving the bucket 35.

Furthermore, mounted on the swing frame 21 of the swing structure 20 are the above-mentioned travel hydraulic motors 13, 14, the swing hydraulic motor 27, the boom cylinder 32, the arc cylinder 34, and a hydraulic system 40 for driving the bucket cylinder 36 and other hydraulic actuators. The hydraulic system 40 includes a hydraulic pump 41 (FIG. 2) for generating a hydraulic pressure and a control valve 42 (FIG. 2) for providing drive control of various actuators. The hydraulic pump 41 is driven by the engine 22.

The system configuration of electric equipment and hydraulic equipment in the hydraulic excavator will now be outlined. As shown in FIG. 2, the driving force of the engine 22 is transmitted to the hydraulic pump 41. In accordance with a swing operation command (hydraulic pilot signal) from a swing control lever device (not shown), the control valve 42 controls the flow rate and direction of a hydraulic fluid supplied to the swing hydraulic motor 27. Further, in accordance with an operation command (hydraulic pilot signal) from a control lever device irrelevant to swinging, the control valve 42 controls the flow rate and direction of a hydraulic fluid supplied to the boom cylinder 32, the arm cylinder 34, the bucket cylinder 36, and the travel hydraulic motors 13, 14.

The electric operating system includes the drive system, the electrical storage device, a main relay 56, and insulation resistance degradation detection devices 90A, 90B. The drive system includes the above-mentioned assist power generation motor 23, the swing electric motor 25, a power control unit 55 having electrical parts for providing drive control of the above two motors, and a main controller 80. The electrical storage device includes the electric double layer capacitor 24. The main relay 56 breaks the electrical connection between the electrical storage device and the drive system.

The power control unit 55 included in the drive system includes, for example, a chopper 51, inverters 52, 53, and a smoothing capacitor 54. The main relay 56 includes relays 57A, 57B, a relay 57C, and a relay 103. The relay 57C forms an inrush current prevention circuit together with a resistor 58. The relay 103 is used for the later-described insulation resistance degradation detection devices.

DC power from the capacitor 24 is boosted to a predetermined busbar voltage by the chopper 51 and input to the inverter 52 for driving the swing electric motor 25 and to the inverter 53 for driving the assist power generation motor 23. The relays 57A, 57B are main contactors and used to shut off the supply of an electrical charge from the capacitor 24 to the electric operating system. In a state where a capacitor in the chopper 51 is not charged, the inrush current prevention circuit, which is formed by the relay 57 and the resistor 58, charges the capacitor in the chopper 51 by supplying a limited electrical current through a path in the circuit before the closure of the relays 57A, 57B. The smoothing capacitor 54 is used to stabilize the busbar voltage.

The rotating shaft of the swing electric motor 25 is coupled to that of the swing hydraulic motor 27 in order to drive the swing structure 20 through the speed reduction mechanism 26. The capacitor 24 is charged or discharged depending on the drive status of the assist power generation motor 23 and of the swing electric motor 25 (depending on whether power running or regeneration is in progress). As shown in FIG. 2, the capacitor 24 and the main relay 56 are disposed in a housing for an electrical storage unit 59.

The main controller 80 uses an operation command signal, a pressure signal, a rotation speed signal, and other signals not shown in FIG. 2 to generate control commands for the control valve 42 and the power control unit 55 for the purpose, for instance, of switching between a hydraulic-only swing mode and a hydraulic/electric complex swing mode, exercising swing control in each mode, monitoring for electric operating system abnormalities, and performing energy management. An electromagnetic proportional valve 75 converts an electrical signal supplied from the main controller 80 to a hydraulic pilot signal. The hydraulic pilot signal controls the control valve 42.

An electric operating controller 104 exchanges signals with the main controller 80 to provide integrated control of the two inverters 52, 53, the chopper 51, and the later-described first and second insulation resistance degradation detection devices 90A, 90B, all of which are built in the power control unit 55.

The first and second insulation resistance degradation detection devices 90A, 90B are built in the power control unit 55 and connected to various electrical circuits through coupled impedance elements 101A to 101C and first and second detection paths 102A, 102B.

Referring to FIG. 2, the reference numerals 91 to 95 denote portions that can be identified by a detection sequence of the electric operating controller 104 for detecting degradation in insulation resistance and by the first and second insulation resistance degradation detection devices 90A, 90B. The reference numeral 91 denotes a busbar between the capacitor 24 and the main relay 56. The reference numeral 92 denotes a busbar between the main relay 56 and the chopper 51. The reference numeral 93 denotes a busbar between the inverter 52 and the inverter 53. The reference numeral 94 denotes a cable between the assist power generation motor 23 and the inverter 53. The reference numeral 95 denotes a cable between the swing electric motor 25 and the inverter 52.

The electrical circuit of the electric operating system included in the embodiment of the construction machine according to the present invention will now be described with reference to FIG. 3. Elements shown in FIG. 3 and designated by the same reference numerals as those in FIGS. 1 and 2 are identical with their counterpart elements in FIGS. 1 and 2 and will not be redundantly described in detail.

As shown in FIG. 3, the electric operating system generally includes the capacitor 24, the main relay 56, the chopper 51, the main smoothing capacitor 54, the swing electric motor 25, the swing electric motor inverter 52, the assist power generation motor 23, the assist power generation motor inverter 53, the main controller 80, and the insulation resistance degradation detection devices 90A, 90B.

The chopper 51 includes a reactor 51a, IGBTs or other power transistors (hereinafter referred to as the transistors) 51b, 51c, and a smoothing capacitor 51d. The transistors 51b, 51c act as switching elements.

The reactor 51a is connected at one end to a positive electrode of the capacitor 24 through the relay 57A and at the other end to the source of the transistor 51b and to the drain of the transistor 51c. The drain of the transistor 51b is connected to one end of the main smoothing capacitor 54, to the assist power generation motor inverter 53, and to one end of the swing electric motor inverter 52. The source of the transistor 51c is connected to a negative electrode of the capacitor 24 through the relay 57B, to the other end of the main smoothing capacitor 54, to the assist power generation motor inverter 53, and to the other end of the swing electric motor inverter 52. Further, one end of the smoothing capacitor 51d is connected to the one end of the reactor 51a. The other end of the smoothing capacitor 51d is connected to the source of the transistor 51c.

The electric operating controller 104 is connected to the gate of each transistor 51b, 51c to provide switching control. The two transistors 51b, 51c alternately open and close upon receipt of a command from the electric operating controller 104 to not only boost the voltage of the capacitor 24 to a busbar voltage at which the assist power generation motor inverter 53 and the swing electric motor inverter 52 can operate, but also exercise control to maintain the busbar voltage approximately at a predetermined fixed value.

The main smoothing capacitor 54 smoothes a DC voltage. The assist power generation motor inverter 53 and the swing electric motor inverter 52 are connected at one end to the chopper 51 and to the main smoothing capacitor 54, and at the other end to the assist power generation motor 23 and to the swing electric motor 25.

The assist power generation motor inverter 53 and the swing electric motor inverter 52 use a bridge circuit having six transistors 53A, 52A, respectively, acting as switching elements such as IGBTs, and repeatedly turn on/off an electrical current upon receipt of a command from the electric operating controller 104 to vary a pulse width. A three-phase alternating current is then produced to drive the assist power generation motor 23 and the swing electric motor 25.

The assist power generation motor 23 is connected to the power control unit 55 with the cable 94 through a connector 122. The swing electric motor 25 is connected to the power control unit 55 with the cable 95 through a connector 123. Similarly, the power control unit 55 is connected to the electrical storage unit 59 with cables 92, 101D through connectors 120, 121.

The first insulation resistance degradation detection device 90A includes a first voltage waveform generation device 100A, a first detection path 102A, and a first detection section 99A. The first voltage waveform generation device 100A generates an AC waveform or a pulse waveform. The first detection path 102A is connected to a predetermined part of the electrical circuit of the electric operating system in order to apply the AC waveform or the pulse waveform. The first detection section 99A measures, for example, the amplitude level and waveform of an input signal through the first detection path 102A, compares the measured signal with a generated signal to calculate the insulation resistance value of a target circuit relative to a vehicle body frame, and compares the calculated value with a preselected value to detect degradation in insulation resistance. Similarly, the second insulation resistance degradation detection device 90B includes a second voltage waveform generation device 100B, a second detection path 102B, and a second detection section 99B. The second voltage waveform generation device 100B generates an AC waveform or a pulse waveform. The second detection path 102B is connected to a predetermined part of the electrical circuit of the electric operating system in order to apply the AC waveform or the pulse waveform. The second detection section 99B measures, for example, the amplitude level and waveform of an input signal through the second detection path 102B, compares the measured signal with a generated signal to calculate the insulation resistance value of a target circuit relative to the vehicle body frame, and compares the calculated value with a preselected value to detect degradation in insulation resistance.

The first and second insulation resistance degradation detection devices 90A, 90B may use, in some cases, a combination of the first and second voltage waveform generation devices 100A, 100B and a combination of the first and second detection sections 99A, 99B or, in some other cases, use the first and second voltage waveform generation devices 100A, 100B on an individual basis and use the first and second detection sections 99A, 99B on an individual basis.

The first detection path 102A of the first insulation resistance degradation detection device 90A is connected from the first detection section 99A to the negative electrode of the busbar 91 between the capacitor 24 and the main relay 56 through the coupled impedance element 101A, the cable 101D, and the relay 103. The relay 103 is placed in an open (disconnected) state during machine inactivity to avoid a hot line state when the connector 120 or the connector 121 is disconnected for repair or maintenance purposes. The relay 103 is placed in a closed (connected) state when the first insulation resistance degradation detection device 90A or the first voltage waveform generation device 100A is used to detect degradation in insulation resistance.

One portion of the second detection path 102B of the second insulation resistance degradation detection device 90B that is routed from the second detection section 99B through a junction is connected to the positive electrode at one end each of the assist power generation motor inverter 53 and the swing electric motor inverter 52 through the coupled impedance element 101B. Meanwhile, the other portion that is routed from the second detection section 99B through the junction is connected to the negative electrode at one end each of the assist power generation motor inverter 53 and the swing electric motor inverter 52 through the coupled impedance element 101C.

The first and second voltage waveform generation devices 100A, 100B are voltage waveform generators for injecting a voltage waveform so that the potential of the electrical circuit relative to the potential of the vehicle body frame changes, for example, temporally in a pulsed manner.

A detection sequence for identifying insulation resistance degradation is described below. As described above, the electric operating system is configured so that the switching elements 53A, 52A for the assist power generation motor inverter 53 and the swing electric motor inverter 52, the transistors 51b, 51c for the chopper 51, and the main relay 56 can be opened and closed by signals from the electric operating controller 104. Insulation resistance degradation can be identified when the electric operating controller 104 monitors detection signals from the first and second insulation resistance degradation detection devices 90A, 90B while the opening and closing of the above-mentioned elements are controlled.

Operations performed by the insulation resistance degradation detection devices included in the embodiment of the construction machine according to the present invention will now be described with reference to FIG. 3.

### (1) Detecting insulation resistance degradation around the electrical storage device when the main relay 56 is open

Insulation resistance degradation in the busbar 91 between the capacitor 24 in the electrical storage unit 59 and the main relay 56 is detected in the following sequence.

When the relays 57A, 57B of the main relay 56 are in the open (disconnected) state, the relay 103 is closed (connected). Subsequently, a voltage waveform is generated from the first voltage waveform generation device 100A and applied to the negative electrode of the busbar 91 between the capacitor 24 and the main relay 56. The first insulation resistance degradation detection device 90A then measures, for example, the amplitude level and waveform of an input signal, compares the measured signal with a generated signal to calculate the insulation resistance value of a target circuit relative to the vehicle body frame, and compares the calculated value with a preselected value to detect whether insulation resistance is degraded.

### (2) Detecting insulation resistance degradation around the electric operating system when the main relay 56 is open

When the relays 57A, 57B of the main relay 56 are in the open (disconnected) state, the second insulation resistance degradation detection device 90B detects, in the first step, degradation in the insulation resistance of the positive and negative electrodes of the busbar 93 between the swing electric motor inverter 52 and the assist power generation motor inverter 53.

In the second step, either the upper side or lower side of the switching element 53A of the assist power generation motor inverter 53 is closed to detect degradation in the insulation resistance of the cable 94 between the assist power generation motor 23 and the assist power generation motor inverter 53. Similarly, either the upper side or lower side of the switching element 52A of the swing electric motor inverter 52 is closed to detect degradation in the insulation resistance of the cable 95 between the swing electric motor 25 and the swing electric motor inverter 52.

In the third step, the transistor 51b of the chopper 51 is closed to detect degradation in the insulation resistance of the positive electrode of the busbar 92 between the main relay 56 and the chopper 51. Detection of the insulation resistance degradation around the electric operating system is completely achieved by performing the first to third steps described above.

### (3) Performing insulation resistance degradation detection and local abnormality diagnosis when the main relay 56 is connected

When the relays 57A, 57B of the main relay 56 are in the closed (connected) state, the relay 103 is closed (connected). Subsequently, the first voltage waveform generation device 100A generates a voltage waveform. Both the first detection section 99A of the first insulation resistance degradation detection device 90A and the second detection section 99B of the second insulation resistance degradation detection device 90B detect the waveform and calculate an insulation resistance value to detect whether insulation resistance is degraded. The electric operating controller 104 compares the results of calculations performed by the two detection sections 99A, 99B to verify whether the first and second insulation resistance degradation detection devices 90A, 90B are normal.

Similarly, the second voltage waveform generation device 100B may generate a voltage waveform to let both the first detection section 99A of the first insulation resistance degradation detection device 90A and the second detection section 99B of the second insulation resistance degradation detection device 90B detect the waveform and calculate an insulation resistance value to detect whether insulation resistance is degraded, thereby verifying whether the first and second insulation resistance degradation detection devices 90A, 90B are normal.

### (4) Performing failure diagnosis of the main relay 56

A failure diagnosis procedure for detecting, for example, stuck contacts of the main relay 56 is described below.

When the relays 57A, 57B of the main relay 56 are in the closed (connected) state, the relay 103 is closed (connected). Subsequently, the first voltage waveform generation device 100A generates a voltage waveform in order to verify that the second detection section 99B of the second insulation resistance degradation detection device 90B detects the waveform. The next step is to verify that the second detection section 99B does not detect the waveform after the relays 57A, 57B, 57C are all opened (disconnected). Similarly, the second voltage waveform generation device 100B may generate a voltage waveform to verify whether the first detection section 99A of the first insulation resistance degradation detection device 90A detects the waveform.

When the relays 57A, 57B, 57C of the main relay 56 are in the open (disconnected) state, the relay 103 is closed (connected). Subsequently, the first voltage waveform generation device 100A generates a voltage waveform in order to verify that the second detection section 99B of the second insulation resistance degradation detection device 90B does not detect the waveform. The next step is to verify that the second detection section 99B detects the waveform after one of the relays 57A, 57B, 57C is closed (connected). Similarly, the second voltage waveform generation device 100B may generate a voltage waveform to verify whether the first detection section 99A of the first insulation resistance degradation detection device 90A detects the waveform.

According to the above-described embodiment of the present invention, the construction machine including the electric operating system 55 having, for example, the electric motors 25, 23, the electrical storage device 24, and the main relay 56 for breaking the electrical connection between the electrical storage device 24 and the electric operating system 55 can perform insulation resistance degradation detection, relay failure diagnosis, and local abnormality diagnosis by using a simple circuit configuration.

In the above-described embodiment, it is assumed that the first and second insulation resistance degradation detection devices 90A, 90B can apply a voltage waveform, such as a pulse waveform, to an electrical circuit, measure the insulation resistance value of a target circuit relative to the vehicle body frame in accordance, for instance, with the amplitude level and waveform of a signal of a measurement section, and identify insulation resistance degradation by following the detection sequence. However, the method of identifying the insulation resistance degradation is not limited to the above-described one.

Although an embodiment of the present invention has been described on the assumption that the present invention is applied to a hydraulic excavator, the present invention is applicable not only to hydraulic excavators but also to vehicles and general construction machines having an electric operating system, a relay, and an electrical storage device.

### Description of Reference Numerals

- 10: Travel structure
- 11: Crawler
- 12: Crawler frame
- 13: Right travel hydraulic motor
- 14: Left travel hydraulic motor
- 20: Swing structure
- 21: Swing frame
- 22: Engine
- 23: Assist power generation motor
- 24: Capacitor
- 25: Swing electric motor
- 26: Speed reduction device
- 27: Swing hydraulic motor
- 30: Excavator mechanism
- 31: Boom
- 33: Arm
- 35: Bucket
- 40: Hydraulic system
- 41: Hydraulic pump
- 42: Control valve
- 51: Chopper
- 52: Swing electric motor inverter
- 53: Assist power generation motor inverter
- 54: Smoothing capacitor
- 55: Power control unit
- 56: Main relay
- 57A: Relay
- 57B: Relay
- 57C: Relay
- 58: Resistor
- 59: Electrical storage unit
- 80: Main controller
- 90A: First insulation resistance degradation detection device
- 90B: Second insulation resistance degradation detection device
- 99A: First detection section
- 99B: Second detection section
- 100A: First voltage waveform generation device
- 100B: Second voltage waveform generation device
- 102A: First detection path
- 102B: Second detection path
- 103: Relay
- 104: Electric operating controller

## Claims

1. A construction machine comprising:
an electric operating system that has electric motors (23, 25), a drive system (55) including an electrical circuit and a controller for driving and controlling the electric motors, an electrical storage device (24), and a relay (56) for electrically connecting the electrical storage device to the drive system and electrically disconnecting the electrical storage device from the drive system;
wherein the electric operating system includes
a first insulation resistance degradation detection device (90A), the detection device (90A) including a first voltage waveform generation device (100A) and a first detection section (99A), the first detection section (99A) being connected to the electrical storage device (24) and to the first voltage waveform generation device (100A) with respect to the relay (56) and adapted to detect degradation in the insulation resistance of the electrical storage device (24) by measuring waveform changes input from the first voltage waveform generation device (100A), and
a second insulation resistance degradation detection device (90B), the detection device (90B) including a second voltage waveform generation device (100B) and a second detection section (99B), the second detection section (99B) being connected to the drive system (55) and to the second voltage waveform generation device (100B) with respect to the relay (56) and adapted to detect degradation in the insulation resistance of the drive system (55) by measuring waveform changes input from the second voltage waveform generation device (100B).

2. The construction machine according to claim 1,
wherein the first and second detection sections (99A, 99B) in the first and second insulation resistance degradation detection devices (90A, 90B) are electrically connected to the second and first voltage waveform generation devices (100A, 100B) so as to acquire voltage waveforms from both the second and first voltage waveform generation devices (100A, 100B) in order to be able to verify the normality of the relay (56).

3. The construction machine according to claim 1,
wherein the first insulation resistance degradation detection device (90A) detects degradation in the insulation resistance around the electrical storage device (24) when the relay (56) is open.

4. The construction machine according to claim 1,
wherein the second insulation resistance degradation detection device (90B) is connected to positive and negative electrodes of the electrical circuit in the drive system (55) through impedance elements (101B, 101C).

5. The construction machine according to claim 1,
wherein the first and second insulation resistance degradation detection devices (90A, 90B) are disposed toward the drive system (55) with respect to the relay (56), and
wherein the first insulation resistance degradation detection device (90A) is connected from the drive system (55) to the electrical storage device (24) through a cable (101D) and another relay (103).
